# EUROPEAN PATENT APPLICATION

(11) **EP 4 682 560 A1**
(43) Date of publication of application: **21.01.2026**
(21) Application number: 23927470.7
(22) Date of filing: 15.03.2023
(51) Int. Cl.: G01R 31/392, G01R 31/396

(54) **INFORMATION PROCESSING DEVICE, INFORMATION PROCESSING METHOD, PROGRAM, AND INFORMATION PROCESSING SYSTEM**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: HATANO, Hisaaki, Tokyo 105-0023 (JP); YAMAMOTO, Takahiro, Tokyo 105-0023 (JP); MARUCHI, Kohei, Tokyo 105-0023 (JP); MITSUMOTO, Kenji, Kawasaki-shi, Kanagawa 212-0013 (JP)
(74) Representative: Hoffmann Eitle
(86) International application number: PCT/JP2023/010149
(87) International publication number: WO 2024/189850

(57) **Abstract**

An information processing apparatus includes a processing unit. The processing unit calculates frequencies at each of which corresponding one of a plurality of first batteries has a specific attribute based on a plurality of pieces of operation data obtained during operation of a second battery that is a battery including the plurality of first batteries each functioning as a battery, the plurality of pieces of operation data including the specific attribute and identification information for identifying the first battery having the specific attribute, the specific attribute satisfying a predetermined condition in an attribute of the plurality of first batteries. The processing unit identifies the first battery in a specific state among the plurality of first batteries, based on the frequencies.

## Description

### Field

Embodiments of the present invention relate to an information processing apparatus, an information processing method, a program, and an information processing system. Background

A battery system has, for example, a configuration in which battery units are connected in parallel so as to achieve a required storage capacity. The battery unit corresponds to a unit of a battery in which battery modules are connected in series according to a required voltage. The battery module corresponds to a unit of a battery in which battery cells, which are minimum units, are connected in series and parallel.

For control, moment-by-moment measured values of a voltage and a temperature in units of battery cells are used. Meanwhile, in consideration of a data amount, data to be recorded is often data aggregated in units other than the minimum unit, such as the battery unit.

### Citation List

### Patent Literature

Patent Literature 1: JP 6134438 B2
Patent Literature 2: WO 2022/049745 A
Patent Literature 3: JP 5447658 B2
Patent Literature 4: JP 2022-068741 A

### Summary

### Technical Problem

However, in the technology as described above, it may not be possible to identify which of smaller units of batteries is in a specific state such as deterioration from data recorded in a certain unit of the battery. In addition, when data is recorded in a small unit, the data amount may be enormous.

An object of the present invention is to provide an information processing apparatus, an information processing method, a program, and an information processing system capable of more efficiently identifying that a battery is in a specific state.

### Solution to Problem

An information processing apparatus according to an embodiment includes a processing unit. The processing unit is configured to calculate frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries. The processing unit is configured to identify a first battery in a specific state among the plurality of first batteries, based on the frequencies.

### Brief Description of Drawings

FIG. 1 is a block diagram of an information processing system according to an embodiment.
FIG. 2 is a diagram illustrating a configuration example of a battery.
FIG. 3 is a diagram illustrating a configuration example of a battery module.
FIG. 4 is a diagram illustrating an example of operation data.
FIG. 5 is a diagram illustrating an example of a graph visualizing a calculated frequency.
FIG. 6 is a diagram illustrating a graph in which frequencies for respective ranges are displayed in a stacked manner.
FIG. 7 is a diagram illustrating a graph visualizing a frequency for a temperature.
FIG. 8 is a diagram illustrating a graph illustrating a frequency in a case where cell imbalance does not occur.
FIG. 9 is a diagram illustrating a graph illustrating a frequency in a case where the cell imbalance occurs.
FIG. 10 is a diagram illustrating a graph illustrating a frequency in a case where the cell imbalance occurs.
FIG. 11 is a flowchart of deterioration estimation processing.
FIG. 12 is a hardware configuration diagram of an information processing apparatus.

### Description of Embodiments

Hereinafter, a preferred embodiment of an information processing apparatus according to the present invention will be described in detail with reference to the accompanying drawings. Hereinafter, a case where a specific state is a deteriorated state will be described as an example. The specific state is not limited to the deteriorated state, and may be any other state.

Deterioration of a battery system is often caused not by deterioration of all battery cells but by deterioration of some battery cells. Usually, a battery module including a deteriorated battery cell is replaced. Therefore, it is desirable to appropriately identify the deteriorated battery module (hereinafter, referred to as a deteriorated module).

As a method of identifying the deteriorated module, the following method has been proposed.
· A method in which special charge/discharge operation is performed offline and a measured value that is not normally recorded is used
· A method based on a premise that a measured value in units of battery modules is recorded

However, it is difficult to apply such methods to a large-scale battery system because it is necessary to actually stop operation of the battery system or a data amount of data to be recorded increases.

In addition, the following methods have also been proposed, but with the methods, it can be grasped that there is a deteriorated module in a battery unit, but it is not possible to identify which battery module has deteriorated.
· A method in which deterioration is determined in a state of normally operating the battery system
· A method in which occurrence of deterioration of some battery modules in the battery unit is detected

Therefore, in the present embodiment, in order to reduce the data amount, it is possible to identify a deteriorated battery among small units of batteries (for example, the battery modules) included in a battery by using data during operation (hereinafter, referred to as the operation data) measured for a larger unit of battery (for example, the battery unit).

Hereinafter, an example in which operation data aggregated for a battery unit including a plurality of battery modules is recorded will be described. The plurality of battery modules correspond to a plurality of batteries BA (first batteries) each functioning as a battery. The battery unit corresponds to a battery BB (second battery) that includes the plurality of batteries BA and functions as a battery.

A combination of the battery BA and the battery BB including the plurality of batteries BA is not limited to the above. For example, the same procedure can be applied to the following units of batteries as the battery BA and the battery BB.
· Battery BA: Battery cell, and Battery BB: Battery module
· Battery BA: Battery unit, and Battery BB: Battery system

A name of a unit of each battery such as the battery cell, the battery module, the battery unit, or the battery system is an example, and any other name may be used. For example, a unit of a battery including a plurality of battery modules may be referred to as a battery board or the like.

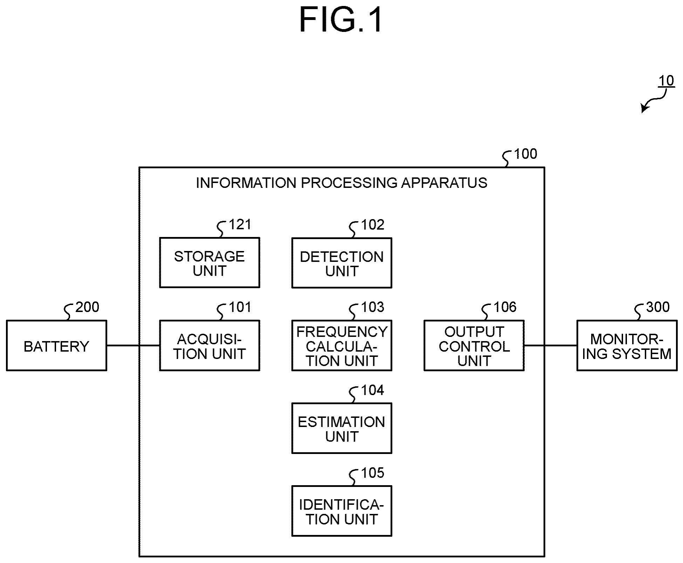

FIG. 1 is a block diagram illustrating an example of a configuration of an information processing system 10 according to the present embodiment. As illustrated in FIG. 1, the information processing system 10 includes an information processing apparatus 100, a battery 200, and a monitoring system 300.

The information processing apparatus 100 and the battery 200, and the information processing apparatus 100 and the monitoring system 300 are connected by networks. The network connecting the information processing apparatus 100 and the battery 200 and the network connecting the information processing apparatus 100 and the monitoring system 300 may be the same network or different networks. The network may be any one of a wireless network, a wired network, and a network combining the wireless network and the wired network.

The battery 200 is a battery (secondary battery) capable of charging and discharging electric energy. The battery 200 may have any configuration as long as the operation data can be acquired.

The battery 200 may be a battery mounted on a mobile body that operates using the electric energy as a power source. Examples of the mobile body include an electric vehicle (EV), an electric bus, a train, a next-generation light rail transit (LRT), a bus rapid transit (BRT), an automatic guided vehicle (AGV), an airplane, and a ship. The battery 200 may be a battery component mounted on an electric device (a smartphone, a personal computer, or the like), a battery for taking in and out electric power for demand response, or the like. The battery 200 may be a battery for other purposes.

The information processing apparatus 100 may sequentially (in real time) collect the operation data at each time measured by the battery 200, or may collectively collect the operation data at a plurality of times. For example, in the case of the battery 200 mounted on the mobile body such as an airplane or a ship, the operation data may be stored in a storage unit provided inside the battery 200, and the operation data stored in the storage unit may be collectively collected when arriving at an airport, a port, or the like.

The battery 200 is charged by a charger disposed in a charging stand, a road shoulder, a parking lot, or the like, or a charger connected to an outlet or the like. The electric power stored in the battery 200 may be dischargeable (reverse flow) to a power grid via the charger. A method of transmitting the electric power from the charger to the battery 200 may be any one of a contact charging method and a non-contact charging method.

Hereinafter, a configuration example of the battery 200 will be described. The battery 200 is not limited to the configuration example. The battery 200 includes a plurality of battery units. The plurality of battery units are connected in series or in parallel. Alternatively, the plurality of battery units are connected in series and in parallel. Alternatively, the battery 200 may include a single battery unit.

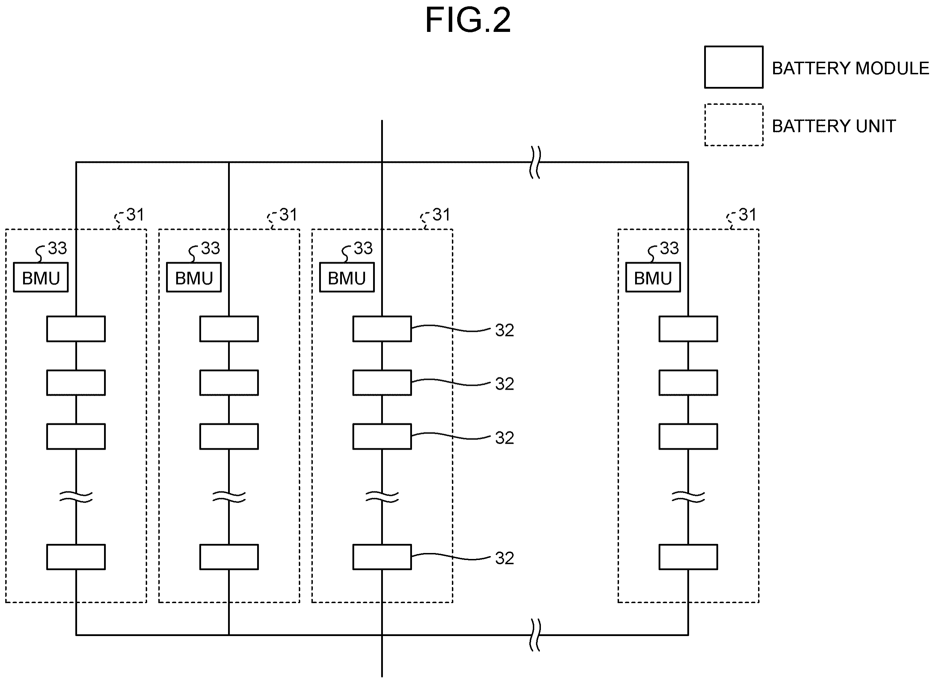

FIG. 2 is a diagram illustrating a configuration example of the battery 200. The battery 200 includes a plurality of battery units 31. Each battery unit 31 includes a plurality of battery modules 32 and a battery management unit (BMU) 33. The plurality of battery modules 32 are connected in series, in parallel, or in series and in parallel. In the example of FIG. 2, the number of battery modules 32 included in each battery unit 31 is the same, but the number of battery modules 32 included in each battery unit 31 is not necessarily the same.

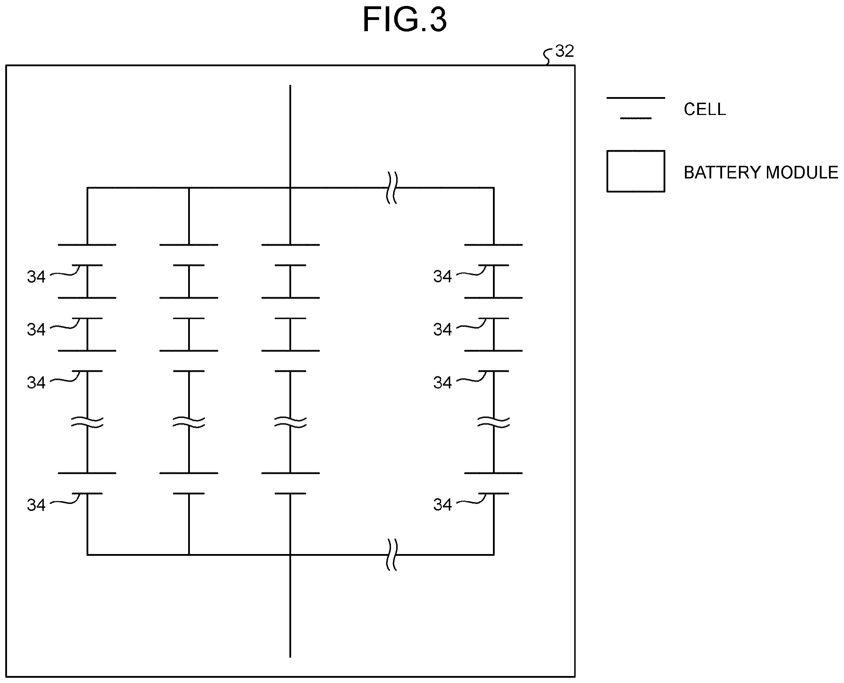

FIG. 3 is a diagram illustrating a configuration example of one battery module 32. The battery module 32 includes a plurality of battery cells 34, a temperature sensor, and a cell monitoring unit (CMU). The plurality of battery cells 34 are connected in series, in parallel, or in series and in parallel. In the example of FIG. 3, two or more directly connected battery cells 34 are further connected in parallel. The configuration of the battery module 32 in FIG. 3 is an example, and the present invention is not limited thereto. For example, the plurality of battery cells 34 connected in parallel may be further connected in series. In such a configuration, for example, a voltage or the like may be measured for each pair of battery cells 34.

Returning to FIG. 1, the monitoring system 300 monitors the battery 200 based on information indicating a state of the battery 200 (hereinafter, state information), the information being provided from the information processing apparatus 100. For example, the monitoring system 300 generates screen data to be used for monitoring, and displays the generated screen data on a monitor. A user (monitoring staff) grasps the state of the battery 200 to be monitored by referring to the screen displayed on the monitor. The monitoring system 300 may control an operation of the battery 200 according to a monitoring result or according to a command of the user.

The information processing apparatus 100 includes a storage unit 121, an acquisition unit 101, a detection unit 102, a frequency calculation unit 103, an estimation unit 104, an identification unit 105, and an output control unit 106.

The storage unit 121 stores various types of information used in the information processing apparatus 100. For example, the storage unit 121 stores the operation data acquired (input) from the battery 200, information indicating an identified deteriorated module, and information (intermediate product) obtained during processing of each unit.

The storage unit 121 can be implemented by any generally used storage medium such as a flash memory, a memory card, a random access memory (RAM), a hard disk drive (HDD), or an optical disc.

The acquisition unit 101 acquires various types of information used in the information processing apparatus 100. For example, the acquisition unit 101 acquires the operation data of the battery 200 from the battery 200. The operation data may be acquired at regular time intervals (for example, one second) or may be acquired irregularly. The acquisition unit 101 stores the acquired operation data in the storage unit 121.

As described above, in the present embodiment, the operation data includes a measured value in units of the battery units 31 in principle. The operation data includes, for example, the following measured values.
· A state of charge (SoC, which indicates a charge level) of the entire battery unit 31
· A voltage of the entire battery unit 31
· A current of the entire battery unit 31
· A temperature in the battery unit 31 (for example, an average temperature of a group of the battery modules 32 in the battery unit 31)

The electric power may be acquired instead of the current. In this case, a value of the current may be calculated by computation from a value of the electric power and a value of the voltage. The SoC is an index indicating the charge level of the battery. For example, the SoC is calculated by dividing an electric power amount (unit Wh) or a charge amount (unit Ah) accumulated in the battery 200 by a rated capacity (the electric power amount or the charge amount) of the battery 200.

The operation data includes, in addition to the measured values (aggregated values) for the entire battery unit 31 as described above, a specific attribute that satisfies a predetermined condition among attributes of the plurality of battery modules 32, and identification information (hereinafter, referred to as a module ID) for identifying the battery module 32 having the specific attribute. These pieces of information are recorded, for example, in order to leave a control history.

The attribute is, for example, at least one of the voltage and the temperature. The condition is, for example, at least one of a condition that the attribute value is included in top n values (n is an integer of 2 or more) in descending in the attributes and a condition that the attribute value is included in top m values (m is an integer of 2 or more) in ascending order in the attributes. In a case where n = 1, the condition is a condition that the attribute is an attribute having the largest attribute value. In a case where m=1, the condition is a condition that the attribute is an attribute having the smallest attribute value.

For example, in a case where the attribute is the voltage and n = 1, the specific attribute indicates that the voltage has the highest value (highest voltage). In a case where the attribute is the voltage and m = 1, the specific attribute indicates that the voltage has the lowest value (lowest voltage). In a case where the attribute is the voltage and the highest voltage and the lowest voltage are used as the specific attributes, the operation data includes the following measured values.
· The highest voltage and the module ID of the battery module 32 for which the highest voltage has been measured
· The lowest voltage and the module ID of the battery module 32 for which the lowest voltage has been measured

In a case where the attribute is the temperature, the operation data includes, for example, the following measured values.
· The highest temperature and the module ID of the battery module 32 for which the highest temperature has been measured
· The lowest temperature and the module ID of the battery module 32 for which the lowest temperature has been measured

The attribute may be one or both of the voltage and the temperature. In a case where the battery 200 is a storage battery, the voltage may be one or both of a voltage during charging and a voltage during discharging.

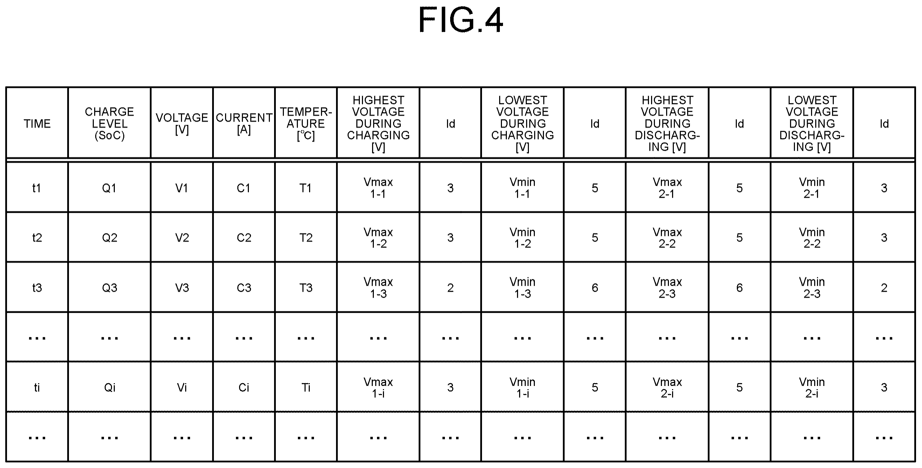

FIG. 4 is a diagram illustrating an example of the operation data. As illustrated in FIG. 4, the operation data includes a time, an SoC, a voltage, a current, a temperature, a module ID (Id) corresponding to the highest voltage during charging, a module ID (Id) corresponding to the lowest voltage during charging, a module ID (Id) corresponding to the highest voltage during discharging, and a module ID (Id) corresponding to the lowest voltage during discharging.

A data structure of the operation data of FIG. 4 is an example, and the present invention is not limited thereto. For example, the current may be recorded while being divided into a current during charging and a current during discharging. One current may be recorded with different signs for the current during charging and the current during discharging. In this case, for example, it is determined that a current with a positive sign is the current during charging, and a current with a negative sign is the current during discharging. In this case, it is not necessary to separately record the highest voltage and the lowest voltage for charging and discharging. For example, the highest voltage and the lowest voltage may be recorded, and whether the voltage is a voltage during charging or a voltage during discharging may be determined by the sign of the current. In a case where the highest voltage and the lowest voltage are separately recorded for charging and discharging, any one of a value during charging and a value during discharging is recorded at each time.

The detection unit 102 detects whether or not some of the plurality of battery modules 32 have been deteriorated based on a plurality of pieces of operation data. Hereinafter, the deterioration of some of the plurality of battery modules 32 may be referred to as local deterioration, and detection of the local deterioration may be referred to as local deterioration detection.

In a case where the deterioration has occurred in a large number of battery modules 32 among the plurality of battery modules 32 in the battery unit 31, processing of identifying the deteriorated module by using the operation data cannot be executed with high accuracy in some cases. Therefore, in the present embodiment, the detection unit 102 performs the local deterioration detection, and in a case where the local deterioration is detected, the identification unit 105 or the like executes identification processing of identifying the deteriorated module. The information processing apparatus 100 does not have to include the detection unit 102 (does not have to perform the local deterioration detection).

The local deterioration detection by the detection unit 102 may be performed by any method, and for example, a method of detecting the local deterioration by a combination of a state of health (SoH) of the battery unit 31 and a state-of-health ratio (hereinafter, referred to as SoH ratio) can be applied.

The SoH is an index indicating a state of the battery unit 31, and is determined in units of the battery units 31. A method of calculating the SoH may be any method, and for example, a method of calculating the SoH by using at least one of a standard deviation and a variance of the voltage of the battery unit 31 (for example, Patent Literature 1 and Patent Literature 2) can be applied.

The SoH ratio is a ratio of the highest-lowest voltage SoH to the SoH. The highest-lowest voltage SoH is calculated based on the highest voltage and the lowest voltage among the voltages applied to the battery unit 31. The SoH ratio can be calculated by, for example, the method described in Patent Literature 2.

The detection unit 102 determines whether or not the battery unit 31 has deteriorated by each of the SoH and the SoH ratio. The determination method may be any method, and for example, the detection unit 102 determines that the battery unit 31 has deteriorated in a case where the SoH becomes equal to or less than a threshold (a threshold of the SoH). In addition, the detection unit 102 determines that the battery unit 31 has deteriorated in a case where the SoH ratio becomes equal to or lower than a threshold (a threshold of the SoH ratio). Instead of or in addition to comparing the value itself of the SoH or the SoH ratio with the threshold, the detection unit 102 may compare the degree of change in the value with a threshold (a threshold of the degree of change) to determine the deterioration. The degree of change in the value is, for example, a change rate (slope) of the value for each predetermined period. For example, the detection unit 102 determines that the battery unit has deteriorated in a case where the SoH is equal to or less than the threshold (the threshold of the SoH) and a decreasing speed of the SoH is equal to or higher than a threshold (a threshold of the speed).

Furthermore, the detection unit 102 detects whether or not the local deterioration has occurred based on the respective determination results for the SoH and the SoH ratio. For example, in a case where it is determined that the deterioration has occurred based on the SoH and it is determined that the deterioration has not occurred based on the SoH ratio, the detection unit 102 determines that the deterioration is not the local deterioration, in other words, most of the battery modules 32 in the battery unit 31 have deteriorated. In a case other than a case where it is determined that the deterioration has occurred based on the SoH and it is determined that the deterioration has not occurred based on the SoH ratio, when the SoH ratio is equal to or lower than a reference value, the detection unit 102 detects that the local deterioration has occurred. Otherwise, the detection unit 102 determines that the deterioration of the battery module 32 has not occurred.

The frequency calculation unit 103 calculates a frequency at which each of the plurality of battery modules 32 has the specific attribute based on the operation data. In a case where the detection unit 102 is provided, the frequency calculation unit 103 may calculate the frequency when the local deterioration has been detected by the detection unit 102.

A case where the operation data as illustrated in FIG. 4 is used will be described as an example. In FIG. 4, the specific attributes are the highest voltage during charging, the lowest voltage during charging, the highest voltage during discharging, and the lowest voltage during discharging. The frequency calculation unit 103 calculates, for each predetermined period (for example, one day), the frequency at which each of the plurality of battery modules 32 has the specific attribute by using the operation data acquired in the corresponding period (hereinafter, referred to as target period).

The estimation unit 104 estimates, for each of the plurality of battery modules 32, whether or not cell imbalance has occurred based on the frequency. The cell imbalance represents a state in which the SoCs of the plurality of battery cells 34 in the battery module 32 are unequal. The battery module 32 including the battery cells 34 having unequal SoCs exhibits behavior in which the SoC deviates from those of other battery modules 32.

That is, normally, the respective battery modules 32 in one battery unit 31 have the same SoC. However, after some of the battery modules 32 are replaced, there may be an SoC deviation among the plurality of battery modules 32. Since the storage battery has a characteristic that the voltage increases as the SoC increases, a frequency at which the voltage of the battery module 32 having a relatively large SoC has a high value increases, and a frequency at which the voltage of the battery module 32 having a relatively small SoC has a low value increases.

In a situation where the cell balance is not achieved, the identification of the deteriorated module based on the frequency is not normally performed. Therefore, in the present embodiment, the estimation unit 104 estimates whether or not the cell imbalance has occurred, and in a case where the cell imbalance has occurred, the identification unit 105 does not execute deteriorated module identification processing. The deteriorated module identification processing by the identification unit 105 may be executed before estimation processing by the estimation unit 104 or in parallel with the estimation processing, and a deteriorated module identification result does not have to be adopted when the cell imbalance has occurred.

Details of a method of estimating the cell imbalance by the estimation unit 104 are described below. The information processing apparatus 100 does not have to include the estimation unit 104 (does not have to execute cell imbalance estimation processing).

The identification unit 105 executes identification processing of identifying the deteriorated battery module 32 among the plurality of battery modules 32 based on the frequency calculated by the frequency calculation unit 103. In a case where the estimation unit 104 is provided, the identification unit 105 may execute the identification processing when the estimation unit 104 estimates that the cell imbalance has not occurred. Details of the identification processing are described below.

The output control unit 106 controls output of various types of information used in the information processing apparatus 100. For example, the output control unit 106 outputs, to the monitoring system 300, output information indicating the deteriorated module identified by the identification unit 105. The output control unit 106 may output the output information including the frequency of each of the plurality of battery modules 32. The output control unit 106 may output the output information further including the attribute value (for example, the voltage) of the attribute of each of the plurality of battery modules 32.

At least some of the respective units (the acquisition unit 101, the detection unit 102, the frequency calculation unit 103, the estimation unit 104, the identification unit 105, and the output control unit 106) may be implemented by one processing unit. The respective units are implemented by, for example, one or a plurality of processors. For example, the respective units may be implemented by causing a processor such as a central processing unit (CPU) to execute a program, that is, by software. The respective units may be implemented by a processor such as a dedicated integrated circuit (IC), that is, by hardware. The respective units may be implemented by using software and hardware in combination. Further, in the case of using a plurality of processors, each processor may implement one of the respective units, or may implement two or more of the respective units.

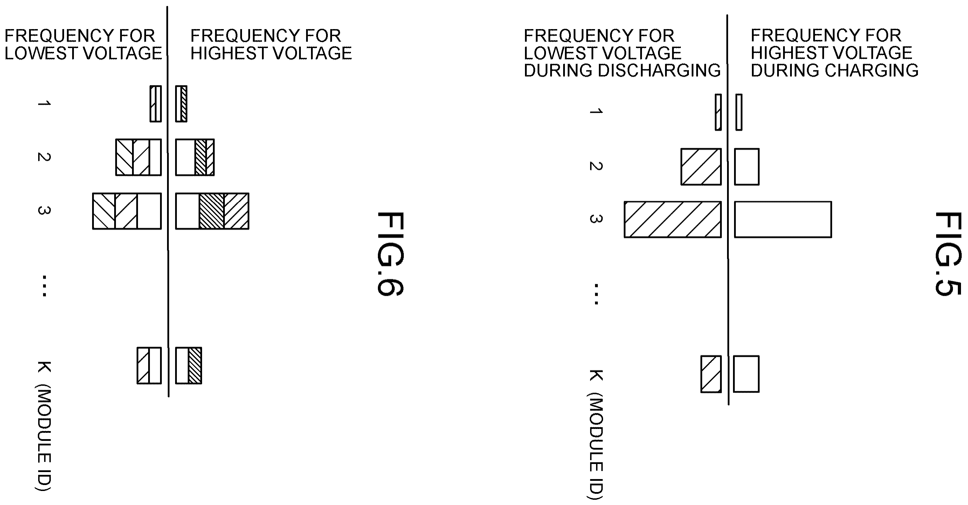

Next, a specific example of the calculation of the frequency and the deteriorated module identification processing based on the frequency will be described. FIG. 5 is a diagram illustrating an example of a graph visualizing the calculated frequency.

FIG. 5 is a graph obtained by aggregating and visualizing the frequency at which each battery module 32 (each module ID) in the battery unit 31 has the highest voltage during charging and the frequency at which each battery module 32 (each module ID) in the battery unit 31 has the lowest voltage during discharging from the operation data of one battery unit 31 acquired in the target period (for example, one day). In FIG. 5 and FIGS. 6 to 10 below, the module ID is represented by a numerical value from 1 to K. K corresponds to the total number of modules.

In the example of FIG. 5, the battery module 32 with the module ID = 3 has the highest voltage during charging and the lowest voltage during discharging at a higher frequency than those of other battery modules 32. Such a frequency state indicates that an internal resistance of the battery module 32 with the module ID = 3 is increased. Deterioration of a capacity of the battery module 32 is detected as an increase in internal resistance. Therefore, the identification unit 105 identifies, as the deteriorated module, the battery module 32 with the module ID = 3 having a higher frequency as illustrated in FIG. 5.

A graph as illustrated in FIG. 5 is an example of the output information including the frequency of each of the plurality of battery modules 32, the output information being output by the output control unit 106. The output control unit 106 may output, together with the output information as illustrated in FIG. 5, the module IDs or the like with higher frequencies as information indicating candidates for the deteriorated module. In this case, for example, the user designates the battery module 32 that is the deteriorated module from among the candidates by referring to the output information such as the graph. The identification unit 105 identifies the designated candidate as the deteriorated module.

The frequency calculation unit 103 may calculate the frequency in consideration of the attribute value of the specific attribute (for example, the voltage). An example in which the highest voltage and the lowest voltage are used as the specific attributes will be described. In this case, for example, the frequency calculation unit 103 divides voltage values of the highest voltage into a plurality of ranges and calculates the frequency for each range.

The output control unit 106 may output a graph in which the frequencies for the plurality of ranges are displayed in a stacked manner. FIG. 6 is a diagram illustrating an example of the graph in which the frequencies for the respective ranges are displayed in this manner. FIG. 6 is an example of the graph in which the frequencies are accumulated by dividing the range of the voltage into three stages. The number of ranges is not limited to three, and may be two or four or more.

By using the attribute value (voltage value) in combination, it is possible to distinguish whether the battery module 32 having a higher frequency is overwhelmingly different in voltage value from those of other battery modules 32 or is slightly different in voltage value from those of other battery modules 32. For example, the battery module 32 having a high frequency for the highest voltage included in a large value range can be determined to be the deteriorated module with more confidence.

As described above, the condition for the specific attribute may be not only the highest value or the lowest value, but also the condition such as that the attribute value is included in the top n values in descending order or that the attribute value is included in the top m values in ascending order. For example, the module IDs with the highest/lowest voltage value, the second highest/lowest voltage value, and the third highest/lowest voltage value, and the voltage values may be recorded in the operation data. In a case where the frequency is visualized as it is without considering the order by using such operation data, it is conceivable that a difference in frequency among the plurality of battery modules 32 becomes small as compared with a case of using only the battery module with the highest/lowest voltage value. In such a case, as illustrated in FIG. 6, it is possible to identify the deteriorated module with higher accuracy by stacking the frequencies in consideration of the voltage values.

The frequency calculation unit 103 may calculate only the frequency for the specific attribute whose attribute value (for example, the voltage value) is within a designated range (for example, a range of being equal to or larger than a designated threshold). As a result, the battery module 32 whose attribute value is greatly different from those of other battery modules 32 can be identified as the deteriorated module.

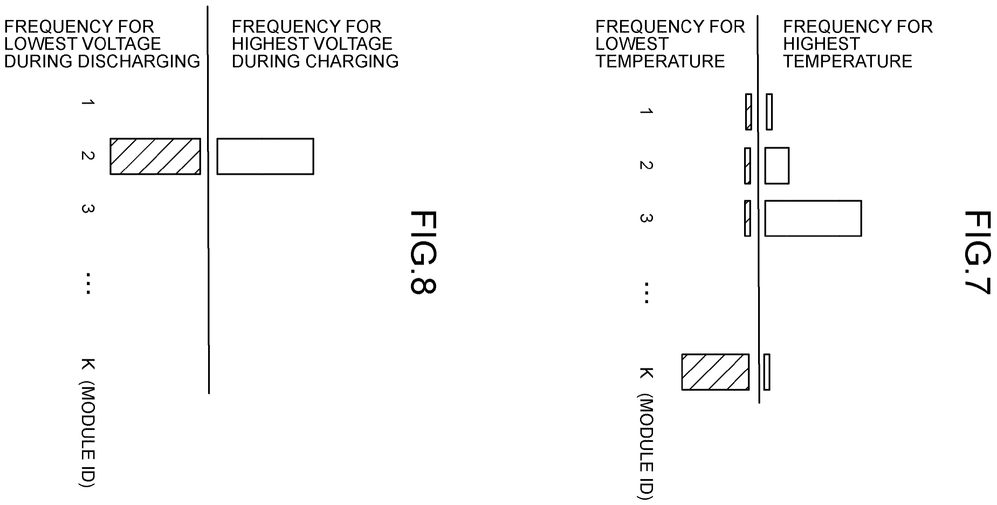

As described above, the attribute for which the frequency is calculated is not limited to the voltage, and may be the temperature, or may be both the voltage and the temperature. FIG. 7 is a diagram illustrating an example of a graph visualizing the frequency calculated for the temperature.

FIG. 7 is a graph obtained by aggregating and visualizing the frequency at which the temperature of each battery module 32 (each module ID) in the battery unit 31 reaches the highest temperature and the frequency at which the temperature of each battery module 32 (each module ID) in the battery unit 31 reaches the lowest temperature from the operation data of one battery unit 31 acquired in the target period (for example, one day).

In general, the storage battery has a property that the internal resistance increases when the temperature is low. Therefore, for example, in a case where a cooling device of the battery 200 cannot uniformly cool the battery module 32 and cold air concentrates on a specific battery module 32, the internal resistance of the battery module 32 having a low temperature increases, and the voltage tends to be the highest voltage and the lowest voltage. In addition, in the battery module 32 having high internal resistance due to the deterioration, more heat is generated during charging and discharging than in a normal battery module 32, and thus, the frequency at which the temperature reaches the highest temperature increases.

The identification unit 105 may identify the deteriorated module in consideration of such properties. For example, the identification unit 105 determines that the battery module 32 having a higher frequency for the lowest temperature is not the deteriorated module because the voltage is only apparently different from those of other battery modules 32 due to an influence of cooling even if the frequency for the highest voltage or the lowest voltage is high. In addition, the identification unit 105 determines that the battery module 32 having a higher frequency for the highest temperature is highly likely to be the deteriorated module.

For the temperature as well, the frequency calculation unit 103 may divide the temperature into a plurality of ranges and calculate the frequency for each range. In addition, the output control unit 106 may output a graph in which the frequencies for the plurality of temperature ranges are displayed in a stacked manner. As a result, for example, it is possible to distinguish whether the battery module 32 having a higher frequency is greatly different in temperature from those of other battery modules 32 or is slightly different in temperature from those of other battery modules 32. In addition, even in a case where a plurality of top module IDs are recorded in the operation data, a temperature deviation can be found by calculating the frequency for each range, similar to the case with the voltage.

In a case where the frequency is calculated for both the voltage and the temperature and a range for which the frequency for the voltage is calculated is limited to the designated range, the frequency calculation unit 103 may use the temperature corresponding to the voltage within the designated range as a calculation target for the frequency.

The identification unit 105 identifies, for example, the battery module 32 having a higher frequency as the deteriorated module. As a method of identifying the deteriorated module according to the frequency, for example, the following methods (M1) to (M4) can be used.

It is assumed that the number of pieces of data collected in the target period (for example, one day) for which the frequency is calculated is N. For example, in a case where one day =24 hours is set as the target period and a sampling interval is 1 second, N is 86400. In a case where the top three values are recorded, N is 3 × 86400 = 259200. In a case where the range for which the frequency is calculated is limited to the designated range, the number of pieces of data obtained after the limitation is N.
(M1) The battery module 32 having the highest frequency is identified as the deteriorated module.
(M2) The battery module 32 having a frequency equal to or higher than a predetermined number of times according to a value of N is identified as the deteriorated module.
(M3) The module IDs are sorted by frequency, the frequency is added in order from the first place in the sorted order, and when the added value exceeds a numerical value determined in advance according to the value of N, the battery modules 32 identified by the module IDs up to the corresponding order are identified as the deteriorated modules.
(M4) Instead of the frequency of (M2) or (M3), a ratio obtained by dividing the frequency by the number N of pieces of data is used.

The identification unit 105 may identify the deteriorated module by combining a plurality of methods among the above methods.

Next, details of the method of estimating the cell imbalance will be described with reference to FIGS. 8 to 10. FIG. 8 is a diagram illustrating an example of a graph of the frequency in a case where the cell imbalance does not occur.

In the example of FIG. 8, the voltage of the battery module 32 with the module ID = 2 increases during charging and decreases during discharging. That is, the battery module 32 with the high voltage and the battery module 32 with the low voltage coincide with each other. In such a case, it can be determined that the cell imbalance has not occurred, and the deteriorated module identification processing based on the frequency can be executed.

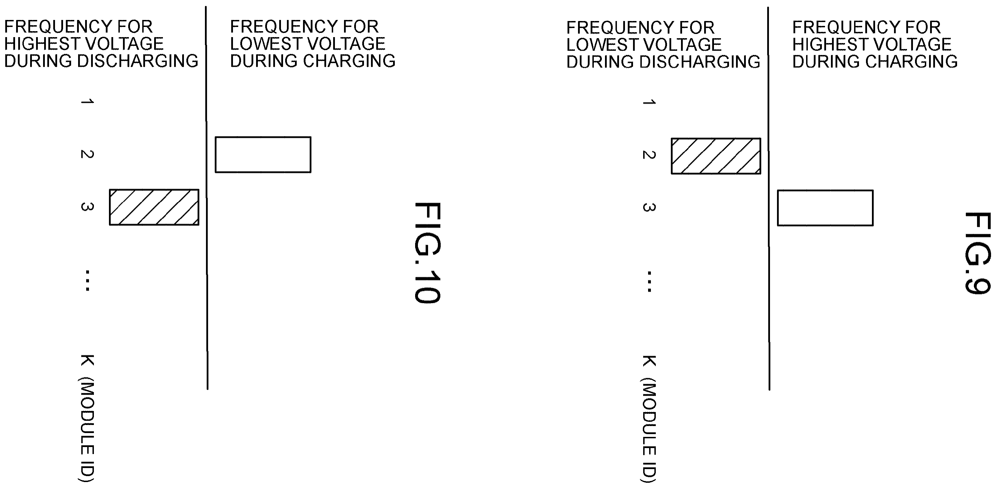

FIGS. 9 and 10 are diagrams illustrating examples of graphs of the frequency in a case where the cell imbalance occurs.

As illustrated in FIG. 9, the battery module 32 (module ID = 3) with the high voltage and the battery module 32 (module ID = 2) with the low voltage may not match each other. One of the reasons is that the battery module 32 with the module ID = 2 and the battery module 32 with the module ID = 3 are not in cell balance.

In the present embodiment, the estimation unit 104 estimates that the cell imbalance has occurred in a case where the battery module 32 having a higher frequency for the high voltage and the battery module 32 having a higher frequency for the low voltage do not coincide with each other. For example, as illustrated in FIG. 9, in a case where the frequency for the highest voltage during charging and the frequency for the lowest voltage during discharging are separated, the estimation unit 104 estimates that cell imbalance has occurred.

The voltage used for the estimation is not limited to the example of FIG. 9. Contrary to FIG. 9, FIG. 10 illustrates an example in which the estimation is performed using the frequency for the lowest voltage during charging and the frequency for the highest voltage during discharging. When the frequency for the lowest voltage during charging and the frequency for the highest voltage during discharging are used as illustrated in FIG. 10, a difference in frequency becomes clearer than the method of FIG. 9, and the estimation of the cell imbalance may be appropriately performed.

The above-described method of estimating the cell imbalance is an example, and the present invention is not limited thereto. Any method may be used as long as the method can detect a state in which the SoCs of the plurality of battery cells 34 in the battery module 32 are unequal.

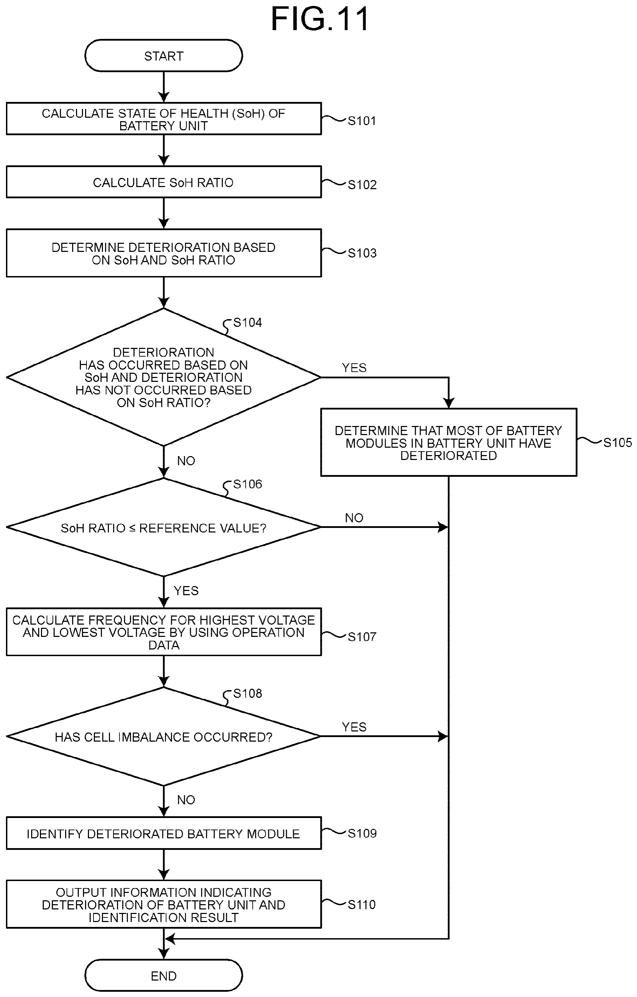

Next, deterioration estimation processing by the information processing apparatus 100 according to the present embodiment will be described. FIG. 11 is a flowchart illustrating an example of the deterioration estimation processing in the present embodiment. In the deterioration estimation processing, the operation data acquired at a constant time interval (for example, 1 second) by the acquisition unit 101 and stored in the storage unit 121 is referred to.

The detection unit 102 calculates the state of health (SoH) for each battery unit 31 by using, for example, the voltage included in the operation data (step S101). In addition, the detection unit 102 calculates the SoH ratio for each battery unit 31 by using the calculated SoH and the operation data (step S102).

Furthermore, the detection unit 102 determines whether or not the battery unit 31 has deteriorated by using each of the SoH and the SoH ratio (step S103). The detection unit 102 determines whether or not it is determined that the deterioration has occurred based on the SoH and it is determined that the deterioration has not occurred based on the SoH ratio (step S104). Hereinafter, a condition for the determination is referred to as a condition C1.

In a case where the condition C1 is satisfied (step S104: Yes), the detection unit 102 determines that the local deterioration has not occurred, in other words, most of the battery modules 32 in the battery unit 31 have deteriorated (step S105). In this case, the deteriorated module is not identified, and the deterioration estimation processing ends.

In a case where the condition C1 is not satisfied (step S104: No), the detection unit 102 determines whether or not the SoH ratio is equal to or lower than the reference value (step S106). In a case where the SoH ratio is higher than the reference value (step S106: No), the detection unit 102 determines that the deterioration of the battery unit 31 has not occurred, the deteriorated module is not identified, and the deterioration estimation processing ends.

In a case where the SoH ratio is equal to or lower than the reference value (step S106: Yes), the detection unit 102 determines that the local deterioration has occurred, and subsequent processing is executed to identify the deteriorated module.

That is, the frequency calculation unit 103 uses the operation data to calculate the frequency at which each battery module 32 in the battery unit 31 has the highest voltage and the lowest voltage (step S107).

The estimation unit 104 estimates whether or not the cell imbalance has occurred by using the calculated frequency (step S108). In a case where the cell imbalance has occurred (step S108: Yes), the deteriorated module is not identified, and the deterioration estimation processing ends.

In a case where the cell imbalance has not occurred (step S108: No), the identification unit 105 executes the identification processing of identifying the deteriorated module among the plurality of battery modules 32 by using the calculated frequency (step S109).

After the identification processing, the output control unit 106 generates the output information indicating that the battery unit 31 has deteriorated and indicating the deteriorated module identified by the identification processing, and outputs the output information to, for example, the monitoring system 300 (step S110).

### (Modified Example)

The battery 200 may be subjected to the following special operation different from normal operation.
· Starting from a stopped state.
· Stopping from an activated state.
· Operating while performing capacity measurement.

When the operation data of the target period in which the special operation is performed is used, a battery module 32 may be erroneously identified as the deteriorated module in the target period. In a modified example, a final deteriorated module is identified based on results of identifying the deteriorated module for a plurality of target periods in order to exclude such a case.

For example, in the present modified example, the identification unit 105 identifies the deteriorated battery module 32 based on the frequency for each predetermined period, and obtains the identified battery module 32 as the candidate for the deteriorated module. Then, the identification unit 105 identifies the battery module 32 that is the candidate in each of a plurality of consecutive target periods as the deteriorated module and outputs the deteriorated module as an identification result. The number of consecutive target periods may be any value of 2 or more.

As described above, in the present embodiment, it is possible to identify the deteriorated battery among small units of batteries (for example, the battery modules) included in a battery by using the operation data measured for a larger unit of battery (for example, the battery unit). Since the operation data of the small unit of the battery is not used, it is possible to avoid an increase in necessary data amount. That is, according to the embodiment, it is possible to more efficiently identify the deterioration of the battery.

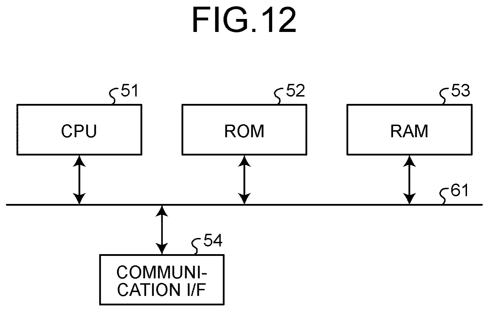

Next, a hardware configuration of the information processing apparatus according to the embodiment will be described with reference to FIG. 12. FIG. 12 is an explanatory diagram illustrating the hardware configuration example of the information processing apparatus according to the embodiment.

The information processing apparatus according to the embodiment includes a control device such as a CPU 51, a storage device such as a read only memory (ROM) 52 and a RAM 53, a communication I/F 54 that is connected to a network and performs communication, and a bus 61 that connects the respective units.

The program executed by the information processing apparatus according to the embodiment is provided by being incorporated in the ROM 52 or the like in advance.

The program executed by the information processing apparatus according to the embodiment may be provided as a computer program product by being recorded as a file in an installable format or an executable format in a computer-readable recording medium such as a compact disk read only memory (CD-ROM), a flexible disk (FD), a compact disk recordable (CD-R), or a digital versatile disk (DVD).

Further, the program executed by the information processing apparatus according to the embodiment may be stored in a computer connected to a network such as the Internet and may be provided by being downloaded via the network. Furthermore, the program executed by the information processing apparatus according to the embodiment may be provided or distributed via a network such as the Internet.

The program executed by the information processing apparatus according to the embodiment can cause a computer to function as each unit of the information processing apparatus described above. In the computer, the CPU 51 can read the program from the computer-readable storage medium onto a main storage device and execute the program.

Configuration examples of the embodiment will be described below.

### (Configuration Example 1)

An information processing apparatus including
a processing unit configured to:
calculate frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries; and
identify a deteriorated first battery among the plurality of first batteries, based on the frequencies.

### (Configuration Example 2)

The information processing apparatus according to Configuration Example 1, in which
the processing unit is configured to:
detect whether or not some of the plurality of first batteries have deteriorated based on the plurality of pieces of operation data, and
calculate the frequencies in a case where it is detected that some of the plurality of first batteries have deteriorated.

### (Configuration Example 3)

The information processing apparatus according to Configuration Example 2, in which
each of the plurality of first batteries is a battery module including a plurality of battery cells, and
the processing unit is configured to:
   estimate whether or not cell imbalance indicating a state in which charge levels of the plurality of battery cells are unequal occurs for each of the plurality of first batteries, based on the frequencies; and
   identify the deteriorated first battery among the plurality of first batteries, based on the frequencies in a case where it is estimated that the cell imbalance does not occur.

### (Configuration Example 4)

The information processing apparatus according to any one of Configuration Examples 1 to 3, in which
each of the plurality of pieces of operation data further includes an attribute value for the specific attribute, and
the processing unit is configured to calculate the frequencies for the specific attribute having an attribute value within a prescribed range.

### (Configuration Example 5)

The information processing apparatus according to any one of Configuration Examples 1 to 4, in which
the condition is at least one of that an attribute value is included in top n values in descending order in the attribute, n being an integer of 2 or more, and that an attribute value is included in top m values in ascending order in the attribute, m being an integer of 2 or more.

### (Configuration Example 6)

The information processing apparatus according to any one of Configuration Examples 1 to 5, in which
the attribute is at least one of a voltage and a temperature.

### (Configuration Example 7)

The information processing apparatus according to Configuration Example 1, in which
the processing unit is configured to output output information indicating the identified first battery.

### (Configuration Example 8)

The information processing apparatus according to Configuration Example 7, in which
the processing unit is configured to output the output information further including at least either of the frequencies of the plurality of first batteries and attribute values of the attribute of the plurality of first batteries.

### (Configuration Example 9)

The information processing apparatus according to any one of Configuration Examples 1 to 8, in which
the processing unit is configured to
calculate the frequencies for each predetermined period,
obtain a candidate for the deteriorated first battery, based on the frequencies for each predetermined period, and identify the first battery that is the candidate in each of a plurality of consecutive periods.

### (Configuration Example 10)

The information processing apparatus according to any one of Configuration Examples 1 to 9, in which
the specific state is a deteriorated state.

### (Configuration Example 11)

The information processing apparatus according to any one of Configuration Examples 1 to 10, in which
the processing unit includes:
a frequency calculation unit configured to calculate the frequencies; and
an identification unit configured to identify the deteriorated first battery among the plurality of first batteries based on the frequencies.

### (Configuration Example 12)

An information processing apparatus including:
a processing unit configured to output output information including frequencies at each of which corresponding one of a plurality of first batteries has a specific attribute, the frequencies being calculated based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries.

### (Configuration Example 13)

An information processing method executed by an information processing apparatus, including:
a frequency calculation step of calculating frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries; and
an identification step of identifying a deteriorated first battery among the plurality of first batteries, based on the frequencies.

### (Configuration Example 14)

A program for causing a computer to execute:
a frequency calculation step of calculating frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries; and
an identification step of identifying a deteriorated first battery among the plurality of first batteries, based on the frequencies.

### (Configuration Example 15)

a second battery that is a battery including a plurality of first batteries each functioning as a battery; and
a processing unit configured to:
   calculate frequencies at each of which corresponding one of the plurality of first batteries has a specific attribute, based on a plurality of pieces of operation data obtained during operation of the second battery, the plurality of pieces of operation data including the specific attribute and identification information for identifying a first battery having the specific attribute, the specific attribute satisfying a predetermined condition in an attribute of the plurality of first batteries; and
   identify a deteriorated first battery among the plurality of first batteries, based on the frequency.

Although some embodiments of the present invention have been described, the embodiments have been presented as examples, and are not intended to limit the scope of the invention. These novel embodiments can be implemented in various other forms, and various omissions, substitutions, and changes can be made without departing from the gist of the invention. The embodiments and modifications thereof are included in the scope and gist of the invention, and are included in the invention described in the claims and the equivalent scope thereof.

### Reference Signs List

- 10: INFORMATION PROCESSING SYSTEM
- 31: BATTERY UNIT
- 32: BATTERY MODULE
- 33: BMU
- 34: BATTERY CELL
- 100: INFORMATION PROCESSING APPARATUS
- 101: ACQUISITION UNIT
- 102: DETECTION UNIT
- 103: FREQUENCY CALCULATION UNIT
- 104: ESTIMATION UNIT
- 105: IDENTIFICATION UNIT
- 106: OUTPUT CONTROL UNIT
- 121: STORAGE UNIT
- 200: BATTERY
- 300: MONITORING SYSTEM

## Claims

1. An information processing apparatus comprising
a processing unit configured to:
calculate frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries; and
identify a first battery in a specific state among the plurality of first batteries, based on the frequencies.

2. The information processing apparatus according to claim 1, wherein
the processing unit is configured to:
detect whether or not some of the plurality of first batteries have deteriorated based on the plurality of pieces of operation data, and
calculate the frequencies in a case where it is detected that some of the plurality of first batteries have deteriorated.

3. The information processing apparatus according to claim 2, wherein
each of the plurality of first batteries is a battery module including a plurality of battery cells, and
the processing unit is configured to:
estimate whether or not cell imbalance indicating a state in which charge levels of the plurality of battery cells are unequal occurs for each of the plurality of first batteries, based on the frequencies; and
identify the first battery in the specific state among the plurality of first batteries, based on the frequencies in a case where it is estimated that the cell imbalance does not occur.

4. The information processing apparatus according to claim 1, wherein
each of the plurality of pieces of operation data further includes an attribute value for the specific attribute, and
the processing unit is configured to calculate the frequencies for the specific attribute having an attribute value within a prescribed range.

5. The information processing apparatus according to claim 1, wherein
the condition is at least one of that an attribute value is included in top n values in descending order in the attribute, n being an integer of 2 or more, and that an attribute value is included in top m values in ascending order in the attribute, m being an integer of 2 or more.

6. The information processing apparatus according to claim 1, wherein
the attribute is at least one of a voltage and a temperature.

7. The information processing apparatus according to claim 1, wherein
the processing unit is configured to output output information indicating the identified first battery.

8. The information processing apparatus according to claim 7, wherein
the processing unit is configured to output the output information further including at least either of the frequencies of the plurality of first batteries and attribute values of the attribute of the plurality of first batteries.

9. The information processing apparatus according to claim 1, wherein
the processing unit is configured to
calculate the frequencies for each predetermined period,
obtain a candidate for the first battery in the specific state, based on the frequencies for each predetermined period, and identify the first battery that is the candidate in each of a plurality of consecutive periods.

10. The information processing apparatus according to claim 1, wherein
the specific state is a deteriorated state.

11. The information processing apparatus according to claim 1, wherein
the processing unit includes:
a frequency calculation unit configured to calculate the frequencies; and
an identification unit configured to identify the first battery in the specific state among the plurality of first batteries based on the frequencies.

12. An information processing apparatus comprising
a processing unit configured to output output information including frequencies at each of which corresponding one of a plurality of first batteries has a specific attribute, the frequencies being calculated based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries.

13. An information processing method executed by an information processing apparatus, comprising:
a frequency calculation step of calculating frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries; and
an identification step of identifying a first battery in a specific state among the plurality of first batteries, based on the frequencies.

14. A program for causing a computer to execute:
a frequency calculation step of calculating frequencies at each of which corresponding one of a plurality of first batteries has a specific attribute, based on a plurality of pieces of operation data obtained during operation of a second battery that is a battery including the plurality of first batteries each functioning as a battery, the plurality of pieces of operation data including the specific attribute and identification information for identifying a first battery having the specific attribute, the specific attribute satisfying a predetermined condition in an attribute of the plurality of first batteries; and
an identification step of identifying a first battery in a specific state among the plurality of first batteries, based on the frequencies.

15. An information processing system comprising:
a second battery that is a battery including a plurality of first batteries each functioning as a battery; and
a processing unit configured to:
calculate frequencies at each of which corresponding one of the plurality of first batteries has a specific attribute, based on a plurality of pieces of operation data obtained during operation of the second battery, the plurality of pieces of operation data including the specific attribute and identification information for identifying a first battery having the specific attribute, the specific attribute satisfying a predetermined condition in an attribute of the plurality of first batteries; and
identify a first battery in a specific state among the plurality of first batteries, based on the frequency.
